# EUROPÄISCHE PATENTSCHRIFT

(11) **EP 4 320 722 B1**
(45) Veröffentlichungstag und Bekanntmachung des Hinweises auf die Patenterteilung: **04.06.2025**
(21) Anmeldenummer: 22724409.2
(22) Anmeldetag: 04.04.2022
(51) Int. Cl.: H02S 40/34

(54) **ANSCHLUSSDOSEN-HALBZEUG, SOLARMODUL-HALBZEUG, SOLARMODUL UND VERFAHREN ZUR HERSTELLUNG EINES SOLARMODULS**
CONNECTION SOCKET SEMI-FINISHED PRODUCT, SOLAR MODULE SEMI-FINISHED PRODUCT, SOLAR MODULE, AND METHOD FOR PRODUCING A SOLAR MODULE
DEMI-PRODUIT DE BOÎTE DE CONNEXION, DEMI-PRODUIT DE MODULE SOLAIRE, MODULE SOLAIRE ET PROCÉDÉ DE PRODUCTION D'UN MODULE SOLAIRE

(30) Priorität: 09.04.2021 DE 102021108875
(43) Veröffentlichungstag der Anmeldung: 14.02.2024
(73) Patentinhaber: Hanwha Q CELLS GmbH, 06766 Bitterfeld-Wolfen (DE)
(72) Erfinder: GÖBEL, Marco, 06766 Bitterfeld-Wolfen (DE)
(74) Vertreter: Adares PartGmbB
(86) Internationale Anmeldenummer: PCT/DE2022/100255
(87) Internationale Veröffentlichungsnummer: WO 2022/214139

(56) Entgegenhaltungen:
- EP-B1- 3 089 356
- CN-A- 106 788 218
- CN-A- 109 327 187
- DE-A1- 102009 022 944
- US-A1- 2013 037 077

## Beschreibung

Die Erfindung betrifft ein Anschlussdosen-Halbzeug und ein Solarmodul-Halbzeug, die zur Herstellung des Solarmoduls miteinander verbindbar sind, ein das Anschlussdosen-Halbzeug und das Solarmodul-Halbzeug aufweisendes Solarmodul und ein Verfahren zur Herstellung des Solarmoduls.

Ein Solarmodul weist üblicherweise ein plattenförmiges Frontseitenelement, ein plattenförmiges Rückseitenelement und ein Verkapselungsmaterial auf, das zwischen dem Frontseitenelement und dem Rückseitenelement angeordnet ist. Das Solarmodul weist weiterhin eine Mehrzahl Solarzellenstrings aus elektrisch üblicherweise in Reihe miteinander verschalteten Solarzellen auf, die zwischen dem Frontseitenelement und dem Rückseitenelement angeordnet sind und mittels des Frontseitenelementes, des Rückseitenelementes und des die Solarzellen umschließenden Verkapselungsmaterials in Form eines Solarmodul-Laminats in einem Verkapselungsvolumen dauerhaft witterungsbeständig verkapselt sind. Die Solarzellenstrings sind üblicherweise mit Hilfe elektrischer Leiterelemente, insbesondere in Form von Querverbindern, innerhalb des Laminats elektrisch miteinander verschaltet. Die elektrische Verschaltung kann je nach Anforderung eine reine Reihenschaltung der Solarzellenstrings oder als eine Kombination von Reihen- und Parallelschaltung von Solarzellenstrings ausgebildet sein. Die verschalteten Solarzellenstrings weisen elektrische Anschlusselemente auf, von denen mindestens ein Pluspol-Anschlusselement und ein Minuspol-Anschlusselement aus dem Verkapselungsvolumen durch eine in dem Rückseitenelement ausgebildete Öffnung herausgeführt sind. Am Solarmodul ist weiterhin im Bereich dieser Öffnung eine Anschlussdose zum dauerhaft witterungsbeständig versiegelten elektrischen Kontaktieren der aus dem Verkapselungsvolumen herausgeführten elektrischen Anschlusselemente fixiert. Die Anschlussdose weist ein Gehäuse auf, in das die Anschlusselemente hineingeführt sind und das weiterhin mit einem Füllmaterial befüllbar ist, um die Anschlusselemente dauerhaft wetterbeständig vor Feuchtigkeit und vor Korrosion zu schützen. Die Anschlussdose ist mit einem ersten Solarmodulkabel als Pluspolkabel des Solarmoduls und mit einem zweiten Solarmodulkabel als Minuspolkabel des Solarmoduls versehen, die mit den Pluspol- und den Minuspol-Anschlusselementen in der Anschlussdose elektrische kontaktiert sind. Über das erste und das zweite Solarmodulkabel lässt sich die vom Solarmodul generierte elektrische Energie abführen.

Aus der CN 106 788 218 A ist ein Solarmodul bekannt, das zwei Pluspol-Kontaktelemente und zwei Minuspol-Kontaktelemente und mehrere zum Kontaktieren eines Solarzellenstrings ausgebildete Anschlussdosen mit jeweils einem Pluspol-Kontaktelement und einem Minuspol-Kontaktelement aufweist. Drei Anschlussdosen sind jeweils über Dosenkabel elektrisch verschaltet, und das Solarmodul weist zwei Solarmodulkabel auf.

DE 10 2009 022944 A1 beschreibt ein Solarpaneel mit einem Solarmodul, einer Eingangsanschlussdose, einer Ausgangsanschlussdose und elektrischen Leitern, die aus dem Solarmodul herausgeführt sind. Zwei der elektrischen Leiter sind mit der bereits befestigten Eingangsanschlussdose, und zwei der elektrischen Leiter sind mit der bereits befestigten Ausgangsanschlussdose kontaktiert. Sechs weitere elektrischen Leiter ragen aus dem Solarmodul hervor und sind noch durch Überbrückungsdosen zu kontaktieren. Die Eingangsanschlussdose ist mittels eines Eingangsanschlussdosen-Befestigungselements mit dem Solarmodul verklebt, und ein Eingangsanschlussdosendeckel kann an dem Solarmodul festgeklebt sein. Das Eingangsanschlussdosen-Befestigungselement weist elektrische und/oder elektronische Bauteile auf.

Es besteht ein stetiger wirtschaftlicher Druck zur Reduktion der Herstellungskosten von Solarmodulen.

Es ist eine Aufgabe der Erfindung, ein Solarmodul bereitzustellen, das auf alternative Weise einfacher und kostengünstiger herstellbar ist.

Die Aufgabe wird durch ein Anschlussdosen-Halbzeug mit dem Merkmalen des Patentanspruchs 1, ein Solarmodul-Halbzeug mit dem Merkmalen des Patentanspruchs 6, ein Solarmodul mit dem Merkmalen des Patentanspruchs 9 und ein Verfahren mit dem Merkmalen des Patentanspruchs 11 gelöst. Vorteilhafte Weiterbildungen und Modifikationen sind in den Unteransprüchen angegeben.

Das Anschlussdosen-Halbzeug und das Solarmodul-Halbzeug sind auf einfachere Weise vorfertigbar. Ein betriebsbereites Solarmodul erhält man durch die Montage des erfindungsgemäßen Anschlussdosen-Halbzeugs auf dem erfindungsgemäßen Solarmodul-Halbzeug. Dabei werden Anschlussdosen-Teilgehäuse des Anschlussdosen-Halbzeugs und korrespondierende Gehäusebasen des Solarmodul-Halbzeugs zu mindestens zwei Anschlussdosen dauerhaft witterungsbeständig verbunden. Die den zwei Anschlussdosen zugeordneten Solarzellenstrings im Inneren des Solarmodul-Laminats sind mittels eines außerhalb des Solarmodul-Laminats zwischen den Gehäusen verlaufenden Dosenkabels elektrisch miteinander verschaltet. Anders als im Stand der Technik erfolgt die Verschaltung der Solarzellenstrings ganz oder teilweise außerhalb des Solarmodul-Laminats. Durch diese Lösung sind im Solarmodul-Laminat angeordneten elektrischen Leiterelemente für die elektrische Verschaltung der Solarzellenstrings überflüssig. Die Anordnung dieser elektrischen Leiterelemente vor dem Laminieren muss oftmals in Handarbeit vorgenommen werden. Außerdem muss beim Laminieren darauf geachtet werden, dass die räumlich gewünschte Anordnung der Solarzellenstrings und ihrer Querverbinder erhalten bleibt. Durch die Verlagerung der Querverbinder aus dem Solarmodul-Laminat heraus ist das auf diese Weise durch das Anschlussdosen-Halbzeug und das Solarmodul-Halbzeug gebildete Solarmodul signifikant vereinfacht und somit kostengünstiger in der Herstellung.

Die Erfindung betrifft ein Anschlussdosen-Halbzeug für ein Solarmodul, aufweisend
- ein erstes Anschlussdosen-Teilgehäuse, das eine erste Kontaktvorrichtung mit einem ersten Pluspol-Kontaktelement und mit einem ersten Minuspol-Kontaktelement aufweist, derart angeordnet und ausgebildet für ein elektrisches Kontaktieren eines oder mehrerer Pluspol-Anschlusselemente und eines oder mehrerer Minuspol-Anschlusselemente von Solarzellenstrings eines Solarmodul-Laminats,
- mindestens ein weiteres Anschlussdosen-Teilgehäuse, das eine weitere Kontaktvorrichtung mit einem weiteren Pluspol-Kontaktelement und einem weiteren Minuspol-Kontaktelement aufweist, derart angeordnet und ausgebildet für ein elektrisches Kontaktieren eines oder mehrerer Pluspol-Anschlusselemente und eines oder mehrerer Minuspol-Anschlusselemente von Solarzellenstrings eines Solarmodul-Laminats, wobei das erste Anschlussdosen-Teilgehäuse und das mindestens eine oder die weiteren Anschlussdosen-Teilgehäuse strukturell getrennt voneinander ausgebildet sind,
- mindestens ein Dosenkabel, das zwischen der ersten Kontaktvorrichtung des ersten Anschlussdosen-Teilgehäuses und der weiteren Kontaktvorrichtung des weiteren Anschlussdosen-Teilgehäuses eine elektrische Verschaltung herstellt,
- ein erstes Solarmodulkabel, das derart mit der ersten Kontaktvorrichtung oder mit der oder einer der weiteren Kontaktvorrichtungen verschaltet ist, dass das erste Solarmodulkabel einen Pluspolanschluss, der über das mindestens eine Dosenkabel in elektrischer Verschaltung verbundenen ersten Kontaktvorrichtung und der weiteren Kontaktvorrichtung oder den weiteren Kontaktvorrichtungen bildet und
- ein zweites Solarmodulkabel, das derart mit der ersten Kontaktvorrichtung oder mit der oder einer der weiteren Kontaktvorrichtungen verschaltet ist, dass das zweite Solarmodulkabel einen Minuspolanschluss, der über das mindestens eine Dosenkabel in elektrischer Verschaltung verbundenen ersten Kontaktvorrichtung und der weiteren Kontaktvorrichtung oder den weiteren Kontaktvorrichtungen bildet.

Das Anschlussdosen-Halbzeug mit seinen mindestens zwei Anschlussdosen-Teilgehäusen stellt bei Verbindung mit dem Solarmodul-Halbzeug eine einfache Verschaltung der Solarzellenstrings des Solarmodul-Halbzeugs bereit. Das Anschlussdosen-Halbzeug kann auf einfache Weise vor der Montage am Solarmodul-Halbzeug vorgefertigt werden. Diese Fertigung kann in einer separaten Fertigungsstätte beispielsweise durch einen Zulieferbetrieb erfolgen. Die mindestens zwei Anschlussdosen-Teilgehäuse stellen zwei strukturell separate Teilgehäuse zwei verschiedener Anschlussdosen dar, sind aber über das Dosenkabel elektrisch miteinander verschaltet. Durch diesen Aufbau ist die Integration und Einlaminierung von elektrischen Leiterelementen wie zum Beispiel Querverbindern zur elektrischen Verschaltung der Solarzellenstrings im Inneren des Solarmodul-Laminats des Solarmodul-Halbzeugs nicht mehr erforderlich.

Bevorzugt sind sowohl das erste Solarmodulkabel und das zweite Solarmodulkabel mit der ersten Kontaktvorrichtung verbunden, während die mindestens eine weitere Kontaktvorrichtung mit keinem Solarmodulkabel verbunden ist, d.h. die mindesten eine weitere Kontaktvorrichtung ist solarmodulkabelfrei ausgebildet. Das erste Anschlussdosen-Teilgehäuse dann ist bei Montage auf ein Solarmodul-Halbzeug Teil einer Haupt-Anschlussdose des so gebildeten Solarmoduls. Aus dieser Haupt-Anschlussdose führen Solarmodulkabel in Form eines Minuspol-Kabels des Solarmoduls und eines Pluspol-Kabels des Solarmoduls, die erlauben, das Solarmodul mit weiteren Solarmodulen zu verschalten. Das mindestens eine weitere Anschlussdosen-Teilgehäuse wird dann Teil einer Satelliten-Anschlussdose, die bei Betrieb des Solarmoduls den generierten elektrischen Strom der ihr zugeordneten Solarzellenstrings über das Dosenkabel zu der Haupt-Anschlussdose leiten kann.

Die erste bzw. weitere Kontaktvorrichtung(en) weisen jeweils ein erstes bzw. weiteres Pluspol-Kontaktelement und ein ersten bzw. weiteres Minuspol-Kontaktelement auf. Die jeweilige Kontaktvorrichtung kann in einer minimalen Variante ausschließlich aus dem jeweiligen Pluspol-Kontaktelement und dem jeweiligen Minuspol-Kontaktelement bestehen. Alternativ kann die jeweilige Kontaktvorrichtung neben dem jeweiligen Pluspol-Kontaktelement und dem jeweiligen Minuspol-Kontaktelement noch weitere strukturelle und funktionale Bestandteile wie beispielsweise ein elektrisches Kontaktband und elektronische Bauelemente aufweisen.

Bevorzugt sind die vorstehend beschriebenen elektrischen Verschaltungen jeweils eine Reihenschaltung. Bevorzugt stellt das mindestens eine Dosenkabel zwischen der ersten Kontaktvorrichtung des ersten Anschlussdosen-Teilgehäuses und der mindestens einen weiteren Kontaktvorrichtung des mindestens einen weiteren Anschlussdosen-Teilgehäuses eine Reihenschaltung her. Andere Varianten sind jedoch ebenso möglich und lassen sich über die extern mit Hilfe des Anschlussdosen-Halbzeugs realisierte elektrische Verschaltung der Solarzellenstrings einfacher verwirklichen.

Bevorzugt enthalten das erste und/oder das mindestens eine weitere Anschlussdosen-Teilgehäuse weiterhin ein oder mehrere elektrische und/oder elektronische Bauteile. Dadurch lassen sich die elektrischen und/oder elektronischen Bauteile bei Bedarf leicht austauschen, wenn das Anschlussdosen-Halbzeug mit einem Solarmodul-Halbzeug zu einem Solarmodul kombiniert ist. Bevorzugt sind die elektrischen und/oder elektronischen Bauteile austauschbar in dem ersten und/oder mindestens einen weiteren Anschlussdosen-Teilgehäuse angeordnet. Dadurch muss bei einem Defekt nicht das betroffene Anschlussdosen-Teilgehäuse ausgetauscht werden, sondern nur das defekte Bauteil. Bevorzugt sind die elektrischen und/oder elektronischen Bauteile alle in dem ersten Anschlussdosen-Teilgehäuse angeordnet, das bei Integration in das Solarmodul Teil der Haupt-Anschlussdose ist, während das oder die weiteren Anschlussdosen-Teilgehäuse frei von elektrischen und/oder elektronischen Bauteilen mit Ausnahme der zwingenden Pluspol- und Minuspol-Kontaktelemente sind.

In einer bevorzugten Ausführungsform enthält das erste Anschlussdosen-Teilgehäuse mindestens eine Bypass-Diode für einen oder mehrere Solarzellenstrings eines Solarmodul-Laminats. Alternativ oder zusätzlich bevorzugt enthält das mindestens eine weitere Anschlussdosen-Teilgehäuse mindestens eine Bypass-Diode für einen Solarzellenstring eines Solarmoduls. Wenn in einem oder mehreren Solarzellenstrings bei Betrieb des Solarmoduls beispielsweise durch Verschmutzung oder Verschattung kein Strom mehr fließen sollte, kann die Bypass-Diode Überhitzung und Defekte vermeiden. In einer bevorzugten Ausführungsform enthält das erste Anschlussdosen-Teilgehäuse mindestens eine Bypass-Diode für mindestens einen Solarzellenstring eines Solarmodul-Laminats und ist die erste Kontaktvorrichtung mit dem ersten Solarmodulkabel und dem zweiten Solarmodulkabel elektrisch verschaltet. Das mindestens eine weitere Anschlussdosen-Teilgehäuse ist Bypass-Dioden-frei und die mindestens eine weitere Kontaktvorrichtung ist nicht mit dem ersten Solarmodulkabel und dem zweiten Solarmodulkabel verbunden, d.h. es ist solarmodulkabelfrei ausgebildet.

Bevorzugt weist das erste Anschlussdosen-Teilgehäuse Ansteuerungs- und/oder Analyse-Elektronik für ein Solarmodul auf. Alternativ oder zusätzlich bevorzugt weist das mindestens eine weitere Anschlussdosen-Teilgehäuse Ansteuerungs- und/oder Analyse-Elektronik für ein Solarmodul auf. Bevorzugter ist das erste Anschlussdosen-Teilgehäuse mit Ansteuerungs- und/oder Analyse-Elektronik für ein Solarmodul ausgebildet, während das das mindestens eine weitere Anschlussdosen-Teilgehäuse Ansteuerungs- und/oder Analyse-Elektronik frei ist.

In einer bevorzugten Ausführungsform ist das erste Anschlussdosen-Teilgehäuse einstückig ausgebildet. Alternativ oder zusätzlich bevorzugt ist das mindestens eine weitere Anschlussdosen-Teilgehäuse einstückig ausgebildet. Bevorzugter sind das erste Anschlussdosen-Teilgehäuse und das mindestens eine weitere Anschlussdosen-Teilgehäuse jeweils einstückig ausgebildet. Dadurch wird der Zusammenbau zur Herstellung des Solarmoduls weiterhin vereinfacht.

In einer bevorzugten Ausführungsform sind das erste Anschlussdosen-Teilgehäuse und/oder das mindestens eine weitere Anschlussdosen-Teilgehäuse jeweils wannenförmig ausgebildet. Dadurch wird genügend Platz für elektrische und/oder elektronische Bauteile bereitgestellt, die in es oder sie integriert werden können.

Bevorzugt weisen das erste Anschlussdosen-Teilgehäuse und das mindestens eine weitere Anschlussdosen-Teilgehäuse Dosen-Rastelemente auf, die ausgebildet sind, mit korrespondierenden Rastelementen einer ersten Gehäusebasis oder einer weiteren Gehäusebasis eines Solarmodul-Halbzeugs zu verrasten. Dadurch ist das Solarmodul mittels einer einfachen, aber sicheren Verbindungsart auf einfache Weise herstellbar.

Ferner betrifft die Erfindung ein Solarmodul-Halbzeug, aufweisend
- ein plattenförmiges Frontseitenelement und ein plattenförmiges Rückseitenelement, wobei das Rückseitenelement mindestens zwei Öffnungen aufweist,
- ein Verkapselungsmaterial, das zwischen dem Frontseitenelement und dem Rückseitenelement angeordnet ist,
- eine Mehrzahl Solarzellenstrings aus elektrisch miteinander verschalteten Solarzellen, die zwischen dem Frontseitenelement und dem Rückseitenelement angeordnet sind und mittels des Frontseitenelementes, des Rückseitenelementes und des die Solarzellen umschließenden Verkapselungsmaterials in Form eines Solarmodul-Laminats in einem Verkapselungsvolumen witterungsbeständig verkapselt sind,
- Pluspol-Anschlusselemente und Minuspol-Anschlusselemente der Solarzellenstrings, die pro Solarzellenstring als Anschlusspaar in Form eines Pluspol-Anschlusselements und eines zugehörigen Minuspol-Anschlusselements aus dem Verkapselungsvolumen durch eine der mindestens zwei Öffnungen herausgeführt sind, wobei die Anschlusspaare jeweils durch die jeweils räumlich nächstliegende der mindestens zwei Öffnungen herausgeführt sind und innerhalb des Laminats kein elektrischer Kontakt zwischen den Solarzellenstrings besteht,
- eine über einer der mindestens zwei Öffnungen am Solarmodul-Halbzeug fixierte erste Gehäusebasis, ausgebildet zum Herstellen eines dauerhaft wetterfesten Gehäuses in Verbindung mit einem aufgesetzten Anschlussdosen-Teilgehäuse und
- mindestens eine über der anderen der mindestens zwei Öffnungen am Solarmodul-Halbzeug fixierte weitere Gehäusebasis, ausgebildet zum Herstellen eines dauerhaft wetterfesten Gehäuses in Verbindung mit einem aufgesetzten weiteren Anschlussdosen-Teilgehäuse.

Anstelle von elektrischen Leiterelementen, beispielsweise in Form von Querverbindern zum Verschalten der Solarzellenstrings im Inneren des Solarmodul-Laminats werden die Solarzellenstrings mittels der mindestens zwei Gehäusebasen in Verbindung mit dem Anschlussdosen-Halbzeug verschaltet, das mindestens ein Dosenkabel aufweist, um die Solarzellenstrings außerhalb des Laminats elektrisch in der gewünschten Weise zu verschalten. Eine Integration der elektrischen Leiterelemente in das Solarmodul-Halbzeug zum elektrischen Verschalten der Solarzellenstrings wird dadurch überflüssig. Bevorzugt ist das Solarmodul-Laminat des Solarmodul-Halbzeugs querverbinderfrei ausgebildet; d.h., es weist im Innern des Solarmodul-Laminats elektrischen Leiterelemente in Form von Querverbindern auf. Es sind somit über elektrische Leiterelemente zur Bildung der Solarzellenstrings selbst keine weiteren elektrischen Leiterelemente zur Verschaltung der gebildeten Solarzellenstrings untereinander innerhalb des Solarmodul-Laminats vorhanden. Dadurch ist es einfacher und kostengünstiger als aus dem Stand der Technik bekannte Solarmodule und Solarmodul-Halbzeuge herstellbar.

In einer bevorzugten Ausführungsform sind die Öffnungen derart im Rückseitenelement des Solarmodul-Halbzeugs positioniert, dass diese über einem Anfangsabschnitt und über einem Endabschnitt mindestens eines Solarzellenstrings zu liegen kommen. Dadurch sind das Anschlusspaar auf einem vergleichsweise kurzen Weg einfach durch die Öffnung aus dem Solarmodul-Laminat herausführbar.

Bevorzugt weisen die erste Gehäusebasis und die mindestens eine weitere Gehäusebasis weitere Rastelemente auf, die ausgebildet sind, um mit dem ersten Anschlussdosen-Teilgehäuse oder dem weiteren Anschlussdosen-Teilgehäuse des Anschlussdosen-Halbzeugs zu verrasten. Dadurch lässt sich auf einfache Weise eine dauerhaft witterungsbeständige Anschlussdose herstellen.

Bevorzugt sind die erste und die mindestens eine weitere Gehäusebasis am Rückseitenelement fixiert beispielsweise mit diesem verklebt. Dadurch lassen sich diese während der Herstellung des Solarmodul-Halbzeugs einfach und automatisiert auf dem Rückseitenelement applizieren. Die erste und die mindestens eine weitere Gehäusebasis sind bevorzugt plattenförmig ausgebildet. Die erste und mindestens eine weitere Gehäusebasis sind frei von elektrischen und/oder elektronischen Bauteilen, wenn davon abgesehen wird, dass das elektrische Anschlusspaar der zugeordneten Solarzellenstrings durch sie hindurchgeführt ist. Bevorzugt weisen die erste Gehäusebasis und die mindestens eine weitere Gehäusebasis jeweils mindestens ein Loch auf, durch das oder die die Anschlusselemente der Solarzellenstrings durchführbar sind.

Weiterhin betrifft die Erfindung ein Solarmodul, die das Solarmodul-Halbzeug gemäß einer oder mehrerer der vorstehend beschriebenen Ausführungsformen und das auf die erste Gehäusebasis und auf die weitere Gehäusebasis aufgesetzte Anschlussdosen-Halbzeug gemäß einer oder mehrerer der vorstehend beschriebenen Ausführungsformen aufweist.

Neben der einfachen Herstellbarkeit des Solarmoduls ist ein Vorteil, dass das Anschlussdosen-Halbzeug und seine elektrischen Komponenten bei Bedarf beispielsweise bei Defekt leicht austauschbar sind.

In einer bevorzugten Ausführungsform sind das erste Anschlussdosen-Teilgehäuse auf der ersten Gehäusebasis und das weitere Anschlussdosen-Teilgehäuse auf der weiteren Gehäusebasis derart angeordnet und fixiert, dass sie eine erste Anschlussdose oder eine weitere Anschlussdose bilden, die jeweils dauerhaft witterungsbeständig verschlossen sind.

Das erste Anschlussdosen-Teilgehäuse und die erste Gehäusebasis bilden die erste Anschlussdose, und das mindestens eine weitere Anschlussdosen-Teilgehäuse und die mindestens eine weitere Gehäusebasis bilden die mindestens eine weitere Anschlussdose. Die erste Anschlussdose ist bevorzugt die Haupt-Anschlussdose und die mindestens eine weitere Anschlussdose ist bevorzugt eine Satelliten-Anschlussdose. Eine Haupt-Anschlussdose ist im Sinne der Erfindung eine Anschlussdose, die mit dem ersten Solarmodulkabel und dem zweiten Solarmodulkabel elektrisch verbunden ist, während eine Satelliten-Anschlussdose eine Anschlussdose ist, die nicht mit einem Solarmodulkabel elektrisch verbunden ist, d.h. sie ist solarmodulkabelfrei ausgebildet. Da die Satelliten-Anschlussdose mit der Haupt-Anschlussdose über mindestens ein Dosenkabel verbunden ist, ist sie in der Lage, bei Betrieb Strom in die Haupt-Anschlussdose zu leiten. Bevorzugt weist das Solarmodul eine Haupt-Anschlussdose und zwei Satelliten-Anschlussdosen auf.

Bevorzugt sind die Pluspol- und Minuspol-Anschlusselemente der Solarzellenstrings und die Pluspol- und Minuspol-Anschlusselemente des Anschlussdosen-Halbzeugs derart komplementär ausgebildet, dass sie beim Aufsetzen des Anschlussdosen-Halbzeugs auf das Solarmodul-Halbzeugs einen elektrischen Kontakt bilden. Beispielsweise sind sie mittels einer Steckverbindung elektrisch verbunden. Bevorzugt sind die Pluspol- und Minuspol-Anschlusselemente des Anschlussdosen-Halbzeugs als weibliche Aufnahmeelemente ausgebildet, und sind die Pluspol- und Minuspol-Anschlusselemente der Solarzellenstrings als männliche Steckelemente ausgebildet.

Das Solarmodul-Halbzeug und das Solarmodul sind bevorzugt als Wafer-Solarmodul-Halbzeug oder als Wafer-Solarmodul ausgebildet ist. Ein Wafer-Solarmodul unterscheidet sich von einem Dünnschicht-Solarmodul insbesondere dadurch, dass es waferbasierte Solarzellen und keine Dünnschicht-Solarzellen aufweist. Waferbasierte Solarzellen weisen eine Dicke größer als 100 µm oder beispielsweise im Bereich von 180 bis 300 µm auf, während Dünnschicht-Solarzellen eine Dicke im Bereich von wenigen µm aufweisen. Bei den Solarzellen kann es sich um Halb-, Drittel, Viertel-, Fünftel- oder Vollzellen handeln.

Die Erfindung betrifft ferner ein Verfahren zur Herstellung eines Solarmoduls, aufweisend folgende Schritte
- Bereitstellen eines Solarmodul-Halbzeugs nach einer oder mehrerer der vorstehend beschriebenen Ausführungsformen,
- Anordnen eines Anschlussdosen-Halbzeugs nach einer oder mehrerer der vorstehend beschriebenen Ausführungsformen, so dass die erste Gehäusebasis des Solarmodul-Halbzeugs mit dem ersten Anschlussdosen-Teilgehäuse verbunden wird und die mindestens eine weitere Gehäusebasis des Solarmodul-Halbzeugs mit dem mindestens einen weiteren Anschlussdosen-Teilgehäuse verbunden wird.

Durch das Verbinden entstehen die vorstehend beschriebene erste Anschlussdose und die mindestens eine weitere vorstehend beschriebene Anschlussdose.

Die Erfindung wird im Folgenden anhand von Ausführungsbeispielen unter Bezugnahme auf die Figuren erläutert. Hierbei zeigen schematisch und nicht maßstabsgerecht:
- Fig. 1: eine Schnittansicht eines erfindungsgemäßen Anschlussdosen-Halbzeugs parallel zu einer durch ein zugehöriges Solarmodul definierten Modulebene;
- Fig. 2: ein elektrisches Schaltbild eines weiteren erfindungsgemäßen Anschlussdosen-Halbzeugs;
- Fig. 3: eine Schnittansicht einer Ausführungsform eines erfindungsgemäßen Solarmodul-Halbzeugs senkrecht zu einer durch das Solarmodul-Halbzeug definierten Modulebene;
- Fig. 4: eine Draufsicht auf das in Figur 3 gezeigte Solarmodul-Halbzeug und
- Fig. 5: eine Draufsicht auf ein Solarmodul gebildet aus dem Solarmodul-Halbzeug aus Figur 4 mit einem aufgesetzten dreiteiligen Anschlussdosen-Halbzeug.

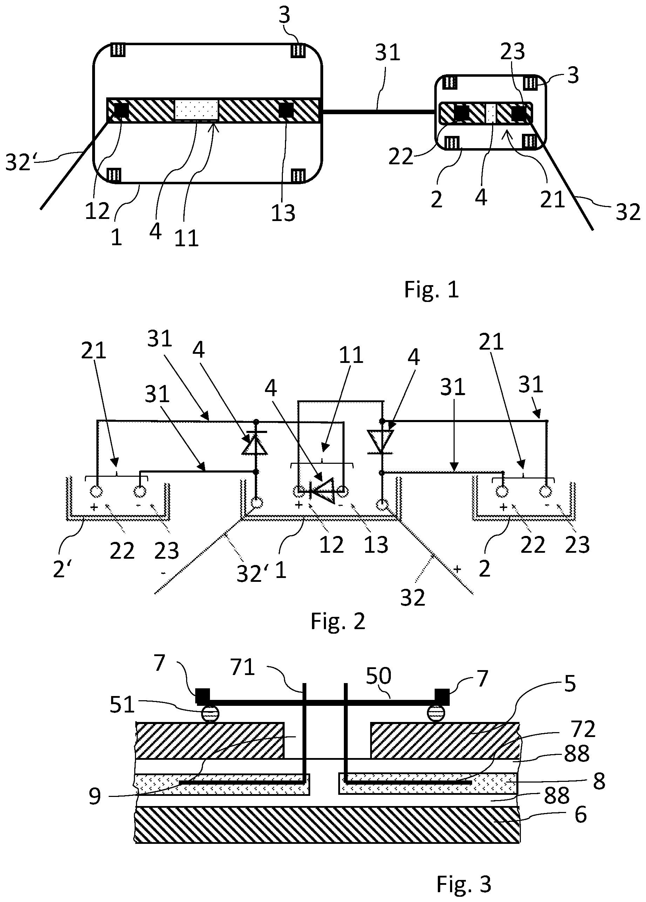

Fig. 1 zeigt eine Schnittansicht eines erfindungsgemäßen Anschlussdosen-Halbzeugs parallel zu einer durch ein zugehöriges Solarmodul-Halbzeug definierten Modulebene. Das Anschlussdosen-Halbzeug für ein Solarmodul-Halbzeug weist ein erstes Anschlussdosen-Teilgehäuse 1 auf, das eine erste Kontaktvorrichtung 11 mit einem ersten Pluspol-Kontaktelement 12 und mit einem ersten Minuspol-Kontaktelement 13 und eine Bypass-Diode 4 aufnimmt. Das erste Pluspol-Kontaktelement 12 und das erste Minuspol-Kontaktelement 13 sind derart angeordnet und ausgebildet für ein elektrisches Kontaktieren eines oder mehrerer Pluspol-Anschlusselemente (nicht gezeigt) und eines oder mehrerer Minuspol-Anschlusselemente (nicht gezeigt) von Solarzellenstrings (nicht gezeigt), die aus dem Solarmodul-Laminat eines Solarmodul-Halbzeugs herausgeführt sind. Die Bypass-Diode 4 ist in der ersten Kontaktvorrichtung 11 für einen oder mehrere Solarzellenstrings eines Solarmodul-Halbzeugs angeordnet und ausgebildet.

Das Anschlussdosen-Halbzeug weist ferner ein weiteres Anschlussdosen-Teilgehäuse 2 auf, das eine weitere Kontaktvorrichtung 21 mit einem weiteren Pluspol-Kontaktelement 22 und einem weiteren Minuspol-Kontaktelement 23 und eine weitere Bypass-Diode 4 aufnimmt. Das weitere Pluspol-Kontaktelement 22 und das weitere Minuspol-Kontaktelement 23 sind derart angeordnet und ausgebildet für ein elektrisches Kontaktieren eines oder mehrerer Pluspol-Anschlusselemente (nicht gezeigt) und eines oder mehrerer Minuspol-Anschlusselemente (nicht gezeigt) von Solarzellenstrings aus dem Solarmodul-Laminat eines Solarmodul-Halbzeugs (nicht gezeigt). Die Bypass-Diode 4 ist für einen oder mehrere Solarzellenstrings des Solarmodul-Halbzeugs angeordnet und ausgebildet. Das erste Anschlussdosen-Teilgehäuse 1 und das weitere Anschlussdosen-Teilgehäuse 2 sind strukturell getrennt voneinander ausgebildet.

Weiterhin weist das Anschlussdosen-Halbzeug ein Dosenkabel 31 auf, das zwischen der ersten Kontaktvorrichtung 11 des ersten Anschlussdosen-Teilgehäuses 1 und der weiteren Kontaktvorrichtung 21 des weiteren Anschlussdosen-Teilgehäuses 2 eine elektrische Verschaltung herstellt.

Das Anschlussdosen-Halbzeug weist ferner ein erstes Solarmodulkabel 32 auf, das derart mit der weiteren Kontaktvorrichtung 21 verschaltet ist, dass das Solarmodulkabel 32 einen Pluspolanschluss, der über das mindestens eine Dosenkabel 31 in elektrischer Verschaltung verbundenen ersten Kontaktvorrichtung 11 und der weiteren Kontaktvorrichtung 21 bildet.

Weiterhin weist das Anschlussdosen-Halbzeug ein zweites Solarmodulkabel 32' auf, das derart mit der ersten Kontaktvorrichtung 11 verschaltet ist, dass das weitere Solarmodulkabel 32' einen Minuspolanschluss, der über das mindestens eine Dosenkabel 31 in elektrischer Verschaltung verbundenen ersten Kontaktvorrichtung 11 und der weiteren Kontaktvorrichtung 21 bildet.

Das erste Anschlussdosen-Teilgehäuse 1 und das weitere Anschlussdosen-Teilgehäuse 2 weisen jeweils Dosen-Rastelemente 3 auf, die jeweils strukturell ausgebildet sind, mit komplementär ausgebildeten Rastelementen von Gehäusebasen (nicht gezeigt) eines Solarmodul-Halbzeugs zu verrasten.

Fig. 2 zeigt ein elektrisches Schaltbild eines weiteren erfindungsgemäßen Anschlussdosen-Halbzeugs. Das in Fig. 2 gezeigte Anschlussdosen-Halbzeug entspricht dem in Fig. 1 gezeigten Anschlussdosen-Halbzeug mit dem Unterschied, dass es neben einem ersten weiteren Anschlussdosen-Teilgehäuse 2 ein weiteres zweites Anschlussdosen-Teilgehäuse 2' aufweist. Weiterhin weist das erste Anschlussdosen-Teilgehäuse 1 zwei weitere Bypass-Dioden 4 auf, während das erste weitere Anschlussdosen-Teilgehäuse 2 und auch das zweite weitere Anschlussdosen-Teilgehäuse 2' jeweils keine Solarzellenstring-Bypass-Diode enthält. Schließlich ist das Solarmodulkabel 32 mit dem ersten Anschlussdosen-Teilgehäuse 1 anstelle mit dem erste weiteren Anschlussdosen-Teilgehäuse 2 verbunden. Das weitere Anschlussdosen-Teilgehäuse 2' weist eine weitere Kontaktvorrichtung 21 mit einem weiteren Pluspol-Kontaktelement 22 und einem weiteren Minuspol-Kontaktelement 23 auf. Das weitere Pluspol-Kontaktelement 22 und das weitere Minuspol-Kontaktelement 23 sind derart angeordnet und ausgebildet für ein elektrisches Kontaktieren eines oder mehrerer Pluspol-Anschlusselemente (nicht gezeigt) und eines oder mehrerer Minuspol-Anschlusselemente (nicht gezeigt) von Solarzellenstrings (nicht gezeigt) eines Solarmodul-Laminats. Das erste Anschlussdosen-Teilgehäuse 1 und die weiteren Anschlussdosen-Teilgehäuse 2, 2' sind strukturell getrennt voneinander ausgebildet.

Fig. 3 zeigt eine Schnittansicht einer Ausführungsform eines erfindungsgemäßen Solarmodul-Halbzeugs senkrecht zu einer durch das Solarmodul-Halbzeug definierten Modulebene. Das Solarmodul-Halbzeugs weist ein plattenförmiges Frontseitenelement 6 und ein plattenförmiges Rückseitenelement 5 auf. Im Rückseitenelement 5 sind drei Öffnungen 9 ausgebildet, von denen eine gezeigt ist. Ferner weist das Solarmodul-Halbzeug ein Verkapselungsmaterial 88 auf, das zwischen dem Frontseitenelement 6 und dem Rückseitenelement 5 angeordnet ist. Im Verkapselungsmaterial 88 angeordnet sind eine Mehrzahl Solarzellenstrings (nicht gezeigt) aus elektrisch miteinander verschalteten Solarzellen 8. Die Solarzellenstrings sind mittels des Frontseitenelementes 6, des Rückseitenelementes 5 und des die Solarzellen 8 umschließenden Verkapselungsmaterials 88 in Form eines Solarmodul-Laminats in einem Verkapselungsvolumen dauerhaft witterungsbeständig verkapselt.

Die Solarzellenstrings weisen Pluspol-Anschlusselemente 71 und Minuspol-Anschlusselemente 72 auf, die jeweils pro Solarzellenstring als Anschlusspaar in Form des Pluspol-Anschlusselements 71 und des zugehörigen Minuspol-Anschlusselements 72 aus dem Verkapselungsvolumen durch eine der drei Öffnungen 9 herausgeführt sind, wobei die Anschlusspaare jeweils durch die jeweils räumlich nächstliegende der mindestens zwei Öffnungen 9 herausgeführt sind und innerhalb des Laminats kein elektrischer Kontakt zwischen den Solarzellenstrings besteht.

Das Solarmodul-Halbzeug weist ferner eine über einer der drei Öffnungen 9 am Rückseitenelement 5 beispielsweise mittels Klebstoff 51 fixierte erste Gehäusebasis 50 auf, die zum Herstellen eines dauerhaft wetterfesten Gehäuses in Verbindung mit einem aufgesetzten Anschlussdosen-Teilgehäuse (nicht gezeigt) ausgebildet ist. Die erste Gehäusebasis weist Löcher (nicht gezeigt) auf, durch die die Anschlusselemente 71, 72 von Solarzellenstrings als Anschlusspaar geführt sind. Ferner weist die erste Gehäusebasis Basis-Rastelemente 7 auf, die ausgebildet sind, mit Rastelementen 3 des in Fig. 2 gezeigten ersten Anschlussdosen-Teilgehäuses 1 zu verrasten.

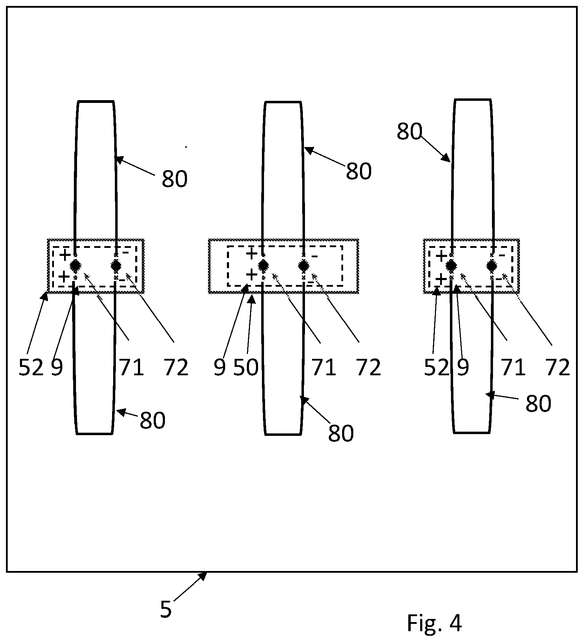

Fig. 4 zeigt eine Draufsicht auf das in Fig. 3 gezeigte Solarmodul-Halbzeug. Das Solarmodul-Halbzeug weist drei Paare Solarzellenstrings 80 auf. Diese sind rein schematisch als Schleifen oberhalb und unterhalb von drei Öffnungen 9 auf der Rückseite des Solarmodul-Halbzeugs dargestellt. Die Pluspol-Anschlusselemente 71 und Minuspol-Anschlusselemente 72 der Solarzellenstrings 80 sind jeweils durch eine der drei Öffnungen 9 aus dem Solarmodul-Laminat des Solarmodul-Halbzeugs herausgeführt. Weiterhin weist das Solarmodul-Halbzeug zwei weitere Gehäusebasen 52 auf, die zum Herstellen einer dauerhaft wetterfesten Anschlussdose in Verbindung mit jeweils einem aufgesetzten weiteren Anschlussdosen-Teilgehäuse (nicht gezeigt) ausgebildet sind. Die weiteren Gehäusebasen 52 sind jeweils über einer der anderen beiden Öffnungen 9 am Rückseitenelement 5 fixiert. Die Öffnungen 9 sind gestrichelt gezeigt, weil sie in dieser Draufsicht unterhalb der Gehäusebasen 50, 52 liegen und daher verdeckt sind.

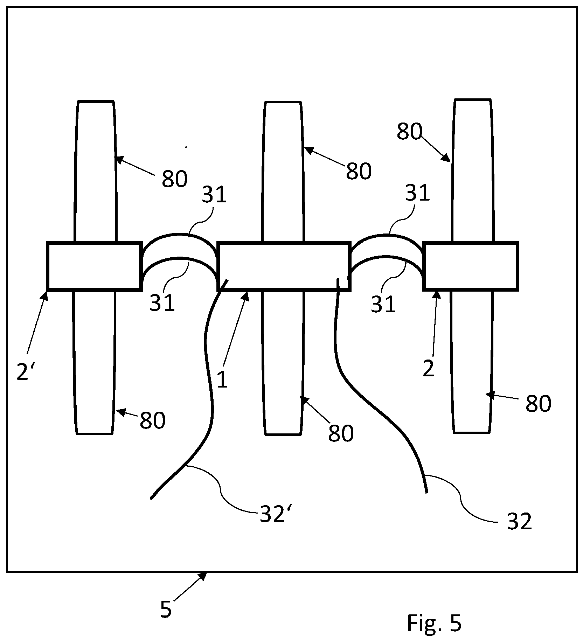

Zur Herstellung einer Ausführungsform des erfindungsgemäßen Solarmoduls wird das in Fig. 3 und 4 gezeigte Solarmodul-Halbzeugs bereitgestellt und dann das in Fig. 2 gezeigte dreiteilige Anschlussdosen-Halbzeug derart angeordnet, dass die erste Gehäusebasis 50 des Solarmodul-Halbzeugs mit dem ersten Anschlussdosen-Teilgehäuse 1 durch Verrastung verbunden wird und die zwei weiteren Gehäusebasen 52 des Solarmodul-Halbzeugs mit jeweils einer der zwei weiteren Anschlussdosen-Teilgehäusen 2 durch Verrastung verbunden werden. Dieses Solarmodul ist beispielhaft in Fig. 5 dargestellt. Das dreiteilige Anschlussdosen-Halbzeug bildet mit seinen Teilgehäusen (1,2,2') zusammen mit den zugehörigen Gehäusebasen (50,52) dauerhaft wetterfest geschlossene Gehäuse und die Dosenkabel 31 zwischen diesen Gehäusen verschalten außerhalb des Solarmodul-Laminats die im Innern des Solarmodul-Laminats angeordneten Solarzellen-Strings 80 in der gewünschten elektrischen Verschaltung.

### Bezugszeichenliste:

- 1: erstes Anschlussdosen-Teilgehäuse
- 2: weiteres Anschlussdosen-Teilgehäuse
- 2': weiteres Anschlussdosen-Teilgehäuse
- 3: Dosen-Rastelement
- 4: Bypassdiode
- 5: Rückseitenelement
- 6: Frontseitenelement
- 7: Basis-Rastelement
- 8: Solarzelle
- 9: Öffnung
- 11: erste Kontaktvorrichtung
- 12: erstes Pluspol-Kontaktelement
- 13: erstes Minuspol-Kontaktelement
- 21: weitere Kontaktvorrichtung
- 22: weiteres Pluspol-Kontaktelement
- 23: weiteres Minuspol-Kontaktelement
- 31: Dosenkabel
- 32: erstes Solarmodulkabel, Pluspolkabel des Solarmoduls
- 32': zweites Solarmodulkabel, Minuspolkabel des Solarmoduls
- 50: erste Gehäusebasis
- 51: Klebstoff
- 52: weitere Gehäusebasis
- 71: Pluspol-Anschlusselement
- 72: Minuspol-Anschlusselement
- 80: Solarzellenstring
- 88: Verkapselungsmaterial

## Patentansprüche

1. Anschlussdosen-Halbzeug für ein Solarmodul aufweisend,
- ein erstes Anschlussdosen-Teilgehäuse (1), das eine erste Kontaktvorrichtung (11) mit einem ersten Pluspol-Kontaktelement (12) und mit einem ersten Minuspol-Kontaktelement (13) aufweist, derart angeordnet und ausgebildet für ein elektrisches Kontaktieren eines oder mehrerer Pluspol-Anschlusselemente (71) und eines oder mehrerer Minuspol-Anschlusselemente (72) von Solarzellenstrings (80) eines Solarmodul-Laminats,
- mindestens ein weiteres Anschlussdosen-Teilgehäuse (2,2'), das eine weitere Kontaktvorrichtung (21) mit einem weiteren Pluspol-Kontaktelement (22) und einem weiteren Minuspol-Kontaktelement (23) aufweist, derart angeordnet und ausgebildet für ein elektrisches Kontaktieren eines oder mehrerer Pluspol-Anschlusselemente (71) und eines oder mehrerer Minuspol-Anschlusselemente (72) von Solarzellenstrings (80) eines Solarmodul-Laminats, wobei das erste Anschlussdosen-Teilgehäuse (1) und das mindestens eine oder die weiteren Anschlussdosen-Teilgehäuse (2,2') strukturell getrennt voneinander ausgebildet sind,
- mindestens ein Dosenkabel (31), das zwischen der ersten Kontaktvorrichtung (11) des ersten Anschlussdosen-Teilgehäuses (1) und der weiteren Kontaktvorrichtung (21) des weiteren Anschlussdosen-Teilgehäuses (2) eine elektrische Verschaltung herstellt,
- ein erstes Solarmodulkabel (32), das derart mit der ersten Kontaktvorrichtung (11) oder mit der oder einer der weiteren Kontaktvorrichtungen (21) verschaltet ist, dass das erste Solarmodulkabel (32) einen Pluspolanschluss der über das mindestens eine Dosenkabel (31) in elektrischer Verschaltung verbundenen ersten Kontaktvorrichtung (11) und der weiteren Kontaktvorrichtung (21) oder den weiteren Kontaktvorrichtungen (21) bildet und
- ein zweites Solarmodulkabel (32'), das derart mit der ersten Kontaktvorrichtung (11) oder mit der oder einer der weiteren Kontaktvorrichtungen (21) verschaltet ist, dass das zweite Solarmodulkabel (32') einen Minuspolanschluss der über das mindestens eine Dosenkabel (31) in elektrischer Verschaltung verbundenen ersten Kontaktvorrichtung (11) und der weiteren Kontaktvorrichtung (21) oder den weiteren Kontaktvorrichtungen (21') bildet.

2. Anschlussdosen-Halbzeug nach Anspruch 1, **dadurch gekennzeichnet, dass** das erste Anschlussdosen-Teilgehäuse (1) mindestens eine Bypass-Diode (4) für einen Solarzellenstring (80) eines Solarmodul-Laminats enthält und/oder dass das mindestens eine weitere Anschlussdosen-Teilgehäuse (2,2') mindestens eine Bypass-Diode (4) für einen Solarzellenstring (80) eines Solarmodul-Laminats enthält.

3. Anschlussdosen-Halbzeug nach Anspruch 1 oder 2, **dadurch gekennzeichnet, dass** das erste Anschlussdosen-Teilgehäuse (1) Ansteuerungs- und/oder Analyse-Elektronik für ein Solarmodul aufweist und/oder dass das mindestens eine weitere Anschlussdosen-Teilgehäuse (2,2') Ansteuerungs- und/oder Analyse-Elektronik für ein Solarmodul aufweist.

4. Anschlussdosen-Halbzeug nach einem der vorangehenden Ansprüchen, **dadurch gekennzeichnet, dass** das erste Anschlussdosen-Teilgehäuse (1) und/oder das mindestens eine weitere Anschlussdosen-Teilgehäuse (2,2') jeweils einstückig ausgebildet sind.

5. Anschlussdosen-Halbzeug nach einem der vorangehenden Ansprüchen, **dadurch gekennzeichnet, dass** das erste Anschlussdosen-Teilgehäuse (1) und/oder das mindestens eine weitere Anschlussdosen-Teilgehäuse (2,2') jeweils wannenförmig ausgebildet sind.

6. Solarmodul-Halbzeug, aufweisend
- ein plattenförmiges Frontseitenelement (6) und ein plattenförmiges Rückseitenelement (5), wobei das Rückseitenelement (5) mindestens zwei Öffnungen (9) aufweist,
- ein Verkapselungsmaterial (88), das zwischen dem Frontseitenelement (6) und dem Rückseitenelement (5) angeordnet ist,
- eine Mehrzahl Solarzellenstrings (80) aus elektrisch miteinander verschalteten Solarzellen (8), die zwischen dem Frontseitenelement (6) und dem Rückseitenelement (5) angeordnet sind und mittels des Frontseitenelementes (6), des Rückseitenelementes (5) und des die Solarzellen (8) umschließenden Verkapselungsmaterials (88) in Form eines Solarmodul-Laminats in einem Verkapselungsvolumen witterungsbeständig verkapselt sind,
- Pluspol-Anschlusselemente (71) und Minuspol-Anschlusselemente (72) der Solarzellenstrings (80), die pro Solarzellenstring (80) als Anschlusspaar in Form eines Pluspol-Anschlusselements (71) und eines zugehörigen Minuspol-Anschlusselements (72) aus dem Verkapselungsvolumen durch eine der mindestens zwei Öffnungen (9) herausgeführt sind, wobei die Anschlusspaare jeweils durch die jeweils räumlich nächstliegende der mindestens zwei Öffnungen (9) herausgeführt sind und innerhalb des Laminats kein elektrischer Kontakt zwischen den Solarzellenstrings (80) besteht,
- eine über einer der mindestens zwei Öffnungen (9) am Solarmodul-Halbzeug fixierte erste Gehäusebasis (50), ausgebildet zum Herstellen eines dauerhaft wetterfesten Gehäuses in Verbindung mit einem aufgesetzten Anschlussdosen-Teilgehäuse (1) und
- mindestens eine über der anderen der mindestens zwei Öffnungen (9) am Solarmodul-Halbzeug fixierte weitere Gehäusebasis (52), ausgebildet zum Herstellen eines dauerhaft wetterfesten Gehäuses in Verbindung mit einem aufgesetzten weiteren Anschlussdosen-Teilgehäuse (2),
wobei die erste und mindestens eine weitere Gehäusebasis frei von elektrischen und/oder elektronischen Bauteilen ist, wenn davon abgesehen wird, dass das elektrische Anschlusspaar der zugeordneten Solarzellenstrings durch sie hindurchgeführt ist.

7. Solarmodul-Halbzeug gemäß Anspruch 6, **dadurch gekennzeichnet, dass** die Öffnungen (9) derart im Rückseitenelement (5) positioniert sind, dass diese über einem Anfangsabschnitt und über einem Endabschnitt mindestens eines Solarzellenstrings (80) zu liegen kommen.

8. Anschlussdosen-Halbzeug gemäß einem der Ansprüche 1 bis 5 oder ein Solarmodul-Halbzeug gemäß Anspruch 6 oder 7, **dadurch gekennzeichnet, dass** das erste Anschlussdosen-Teilgehäuse (1) und das mindestens eine weitere Anschlussdosen-Teilgehäuse (2,2') Dosen-Rastelemente (3) aufweisen, die ausgebildet sind, mit der ersten Gehäusebasis (50) oder der weiteren Gehäusebasis (52) des Solarmodul-Halbzeugs zu verrasten oder dass die erste Gehäusebasis (50) und die mindestens eine weitere Gehäusebasis (52) weitere Basis-Rastelemente (7) aufweisen, die ausgebildet sind, mit dem ersten Anschlussdosen-Teilgehäuse (1) oder dem weiteren Anschlussdosen-Teilgehäuse (2) zu verrasten.

9. Solarmodul, aufweisend ein Solarmodul-Halbzeug gemäß einem der Ansprüche 6 bis 8 und einem auf die erste Gehäusebasis (50) und auf die weitere Gehäusebasis (52) aufgesetzten Anschlussdosen-Halbzeug gemäß einem der Ansprüche 1 bis 5 oder 8.

10. Solarmodul nach Anspruch 9, **dadurch gekennzeichnet, dass** das Anschlussdosen-Teilgehäuse (1) auf der ersten Gehäusebasis (50) und das weitere Anschlussdosen-Teilgehäuse (2) auf der weiteren Gehäusebasis (52) derart angeordnet und fixiert sind, dass sie eine Anschlussdose bzw. eine weitere Anschlussdose bilden, die jeweils dauerhaft witterungsbeständig verschlossen sind.

11. Verfahren zur Herstellung eines Solarmoduls, aufweisend folgende Schritte
- Bereitstellen eines Solarmodul-Halbzeugs nach einem der Ansprüche 6 bis 8,
- Anordnen eines Anschlussdosen-Halbzeugs nach einem der Ansprüche 1 bis 5 oder 8, so dass die erste Gehäusebasis (50) des Solarmodul-Halbzeugs mit dem ersten Anschlussdosen-Teilgehäuse (1) verbunden wird und die mindestens eine weitere Gehäusebasis (52) des Solarmodul-Halbzeugs mit dem mindestens einen weiteren Anschlussdosen-Teilgehäuse (2) verbunden wird.

## Claims

1. A connection socket semi-finished product for a solar module including,
- a first connection socket partial housing (1), which includes a first contact device (11) having a first positive pole contact element (12) and having a first negative pole contact element (13), arranged and designed for electrically contacting one or more positive pole connection elements (71) and one or more negative pole connection elements (72) of solar cell strings (80) of a solar module laminate,
- at least one further connection socket partial housing (2, 2'), which includes a further contact device (21) having a further positive pole contact element (22) and a further negative pole contact element (23), arranged and designed for electrically contacting one or more positive pole connection elements (71) and one or more negative pole connection elements (72) of solar cell strings (80) of a solar module laminate, wherein the first connection socket partial housing (1) and the at least one or the further connection socket partial housings (2, 2') are formed structurally separate from one another,
- at least one socket cable (31), which establishes an electrical connection between the first contact device (11) of the first connection socket partial housing (1) and the further contact device (21) of the further connection socket partial housing (2),
- a first solar module cable (32), which is interconnected with the first contact device (11) or with the or one of the further contact devices (21) such that the first solar module cable (32) forms a positive pole connection of the first contact device (11) connected via the at least one socket cable (31) in electrical interconnection and the further contact device (21) or the further contact devices (21), and
- a second solar module cable (32'), which is interconnected with the first contact device (11) or with the or one of the further contact devices (21) such that the second solar module cable (32') forms a negative pole connection of the first contact device (11) connected via the at least one socket cable (31) in electrical interconnection and the further contact device (21) or the further contact devices (21').

2. The connection socket semi-finished product as claimed in claim 1, **characterized in that** the first connection socket partial housing (1) contains at least one bypass diode (4) for a solar cell string (80) of a solar module laminate and/or that the at least one further connection socket partial housing (2, 2') contains at least one bypass diode (4) for a solar cell string (80) of a solar module laminate.

3. The connection socket semi-finished product as claimed in claim 1 or 2, **characterized in that** the first connection socket partial housing (1) includes activation and/or analysis electronics for a solar module and/or that the at least one further connection socket partial housing (2, 2') includes activation and/or analysis electronics for a solar module.

4. The connection socket semi-finished product as claimed in any one of the preceding claims, **characterized in that** the first connection socket partial housing (1) and/or the at least one further connection socket partial housing (2, 2') are each formed in one piece.

5. The connection socket semi-finished product as claimed in any one of the preceding claims, **characterized in that** the first connection socket partial housing (1) and/or the at least one further connection socket partial housing (2, 2') are each trough-shaped.

6. A solar module semi-finished product, including
- a plate-shaped front side element (6) and a plate-shaped rear side element (5), wherein the rear side element (5) includes at least two openings (9),
- an encapsulation material (88), which is arranged between the front side element (6) and the rear side element (5),
- a plurality of solar cell strings (80) made of electrically interconnected solar cells (8), which are arranged between the front side element (6) and the rear side element (5) and are encapsulated in an encapsulation volume in a weather-resistant manner by means of the front side element (6), the rear side element (5), and the encapsulation material (88) enclosing the solar cells (8) in the form of a solar module laminate,
- positive pole connection elements (71) and negative pole connection elements (72) of the solar cell strings (80) which are led out of the encapsulation volume through one of the at least two openings (9) per solar cell string (80) as a connection pair in the form of a positive pole connection element (71) and an associated negative pole connection element (72), wherein the connection pairs are each led out through the respective spatially closest one of the at least two openings (9) and there is no electrical contact between the solar cell strings (80) within the laminate,
- a first housing base (50) fixed over one of the at least two openings (9) on the solar module semi-finished product and designed to produce a permanently weatherproof housing in connection with an attached connection socket partial housing (1), and
- at least one further housing base (52) fixed over the other of the at least two openings (9) on the solar module semi-finished product and designed to produce a permanently weatherproof housing in connection with an attached further connection socket partial housing (2),
wherein the first and at least one further housing base is free of electrical and/or electronic components, apart from the fact that the electrical connection pair of the assigned solar cell strings is routed through it.

7. The solar module semi-finished product as claimed in claim 6, **characterized in that** the openings (9) are positioned in the rear side element (5) such that they come to rest over a starting section and over an end section of at least one solar cell string (80).

8. The connection socket semi-finished product as claimed in any one of claims 1 to 5 or the solar module semi-finished product as claimed in claim 6 or 7, **characterized in that** the first connection socket partial housing (1) and the at least one further connection socket partial housing (2, 2') include socket detent elements (3), which are designed to latch with the first housing base (50) or the further housing base (52) of the solar module semi-finished product or that the first housing base (50) and the at least one further housing base (52) include further base detent elements (7), which are designed to latch with the first connection socket partial housing (1) or the further connection socket partial housing (2).

9. A solar module, including a solar module semi-finished product as claimed in any one of claims 6 to 8 and a connection socket semi-finished product as claimed in any one of claims 1 to 5 or 8, which is attached to the first housing base (50) and to the further housing base (52).

10. The solar module as claimed in claim 9, **characterized in that** the connection socket partial housing (1) is arranged and fixed on the first housing base (50) and the further connection socket partial housing (2) is arranged and fixed on the further housing base (52) such that they form a connection socket or a further connection socket, which are each permanently closed in a weather-resistant manner.

11. A method for producing a solar module, including the following steps
- providing a solar module semi-finished product as claimed in any one of claims 6 to 8,
- arranging a connection socket semi-finished product as claimed in any one of claims 1 to 5 or 8, so that the first housing base (50) of the solar module semi-finished product is connected to the first connection socket partial housing (1) and the at least one further housing base (52) of the solar module semi-finished product is connected to the at least one further connection socket partial housing (2).

## Revendications

1. Un produit semi-fini de boîte de jonction pour un module solaire,
- un premier sous-boîtier de boîte de jonction (1), qui comporte un dispositif de premier contact (11) avec un premier élément de contact de pôle positif (12) et un premier élément de contact de pôle négatif (13), agencé et conçu de telle manière pour contacter électriquement un ou plusieurs éléments de connexion de pôle positif (71) et un ou plusieurs éléments de connexion de pôle négatif (72) de chaînes de cellules solaires (80) d'un stratifié de module solaire,
- au moins un autre sous-boîtier de boîte de jonction (2,2'), qui comporte un autre dispositif de contact (21) avec un autre élément de contact de pôle positif (22) et un autre élément de contact de pôle négatif (23), agencé et conçu de telle manière pour contacter électriquement un ou plusieurs éléments de connexion de pôle positif (71) et un ou plusieurs éléments de connexion de pôle négatif (72) de chaînes de cellules solaires (80) d'un stratifié de module solaire, dans lequel le premier sous-boîtier de boîte de jonction (1) et le au moins un ou les autres sous-boîtiers de boîte de jonction (2,2') sont structurellement séparés les uns des autres,
- au moins un câble de boîte (31) qui établit une connexion électrique entre le premier dispositif de contact (11) du premier sous-boîtier de boîte de jonction (1) et l'autre dispositif de contact (21) de l'autre sous-boîtier de boîte de jonction (2),
- un premier câble de module solaire (32) qui est connecté au premier dispositif de contact (11) ou au ou à l'un des autres dispositifs de contact (21) de telle sorte que le premier câble de module solaire (32) forme une connexion de pôle positive du dispositif de premier contact (11) relié par au moins un câble de boîte (31) en interconnexion électrique et de l'autre dispositif de contact (21) ou des autres dispositifs de contact (21), et
- un second câble de module solaire (32') qui est connecté au premier dispositif de contact (11) ou au ou à l'un des autres dispositifs de contact (21) de telle sorte que le second câble de module solaire (32') forme une connexion de pôle négative du premier dispositif de contact (11) relié par au moins un câble de boîte (31) en interconnexion électrique et de l'autre dispositif de contact (21) ou des autres dispositifs de contact (21').

2. Le produit semi-fini de boîte de jonction selon la revendication 1, **caractérisée en ce que** le premier sous-boîtier de boîte de jonction (1) contient au moins une diode de dérivation (4) pour une chaîne de cellules solaires (80) d'un stratifié de module solaire et/ou que le au moins un autre sous-boîtier de boîte de jonction (2,2') contient au moins une diode de dérivation (4) pour une chaîne de cellules solaires (80) d'un stratifié de module solaire.

3. Le produit semi-fini de boîte de jonction selon la revendication 1 ou 2, **caractérisée en ce que** le premier sous-boîtier de boîte de jonction (1) comporte de l'électronique de commande et/ou d'analyse pour un module solaire et/ou que le au moins un autre sous-boîtier de boîte de jonction (2,2') comporte de l'électronique de commande et/ou d'analyse pour un module solaire.

4. Le produit semi-fini de boîte de jonction selon l'une quelconque des revendications précédentes, **caractérisé en ce que** le premier sous-boîtier de boîte de jonction (1) et/ou le ou les au moins un autre sous-boîtier de boîte de jonction (2,2') sont chacun d'une seule pièce.

5. Le produit semi-fini de boîte de jonction selon l'une quelconque des revendications précédentes, **caractérisés en ce que** le premier sous-boîtier de boîte de jonction (1) et/ou le au moins un autre sous-boîtier de boîte de jonction (2,2') sont chacun en forme de cuvette.

6. Un produit semi-fini de module solaire, comportant
- un élément avant en forme de plaque (6) et un élément arrière en forme de plaque (5), dans lesquels l'élément arrière (5) comporte au moins deux ouvertures (9),
- un matériau d'encapsulation (88) qui est disposé entre l'élément avant (6) et l'élément arrière (5),
- une pluralité de chaînes de cellules solaires (80) constituées de cellules solaires (8) interconnectées électriquement, qui sont disposées entre l'élément avant (6) et l'élément arrière (5) et sont encapsulées de manière résistante aux intempéries au moyen de l'élément avant (6), de l'élément arrière (5) et du matériau d'encapsulation (88) enfermant les cellules solaires (8) sous la forme d'un stratifié de module solaire dans un volume d'encapsulation,
- des éléments de connexion aux pôles positifs (71) et des éléments de connexion aux pôles négatifs (72) des chaînes de cellules solaires (80), qui sont sortis hors du volume d'encapsulation par l'une des au moins deux ouvertures (9) par chaîne de cellules solaires (80) en tant que paire de connexion sous la forme d'un élément de connexion de pôle positif (71) et d'un élément de connexion de pôle négatif correspondant (72), dans lequel les paires de connexion sont chacune sorties par l'ouverture la plus voisinée spatialement des au moins deux ouvertures (9) et il n'y a pas de un contact électrique entre les chaînes de cellules solaires (80) dans le stratifié,
- une première base de boîtier (50) fixée au produit semi-fini de module solaire par l'intermédiaire d'une des au moins deux ouvertures (9), conçue pour une production d'un boîtier durablement résistant aux intempéries en conjonction avec un sous-boîtier de boîte de jonction attaché (1), et
- au moins une autre base de boîtier (52) fixée au-dessus de l'autre des au moins deux ouvertures (9) du produit semi-fini de module solaire, conçue pour la production d'un boîtier durablement résistant aux intempéries en conjonction avec un autre sous-boîtier boîte de jonction (2) attaché,
dans lequel la première et au moins une autre base de boîtier est exempte de composants électriques et/ou électroniques, à l'exception du fait que la paire de connexion électrique des chaînes de cellules solaires attribuées est acheminée à travers celle-ci.

7. Le produit semi-fini de module solaire selon la revendication 6, **caractérisé en ce que** les ouvertures (9) sont positionnées dans l'élément arrière (5) de telle manière qu'elles viennent se situer au-dessus d'une partie initiale et au-dessus d'une partie finale d'au moins une chaîne de cellules solaires (80).

8. Le produit semi-fini de boîte de jonction selon l'une quelconque des revendications 1 à 5 ou le produit semi-fini de module solaire selon la revendication 6 ou 7, **caractérisé en ce que** le premier sous-boîtier de boîte de jonction (1) et le ou les autres sous-boîtiers de boîte de jonction (2,2') ont des éléments d'encliquetage de boîte (3) qui sont conçus pour s'engager avec la première base de boîtier (50) ou l'autre base de boîte (52) du produit semi-fini de module solaire ou que la première base de boîtier (50) et la ou les autres bases de boîtier (52) comportent d'autres éléments d'encliquetage de base (7) qui sont conçus pour s'engager avec le premier sous-boîtier de boîte de jonction (1) ou l'autre sous-boîtier de boîte de jonction (2).

9. Un module solaire comportant un produit semi-fini de module solaire selon l'une quelconque des revendications 6 à 8 et un produit semi-fini de boîte de jonction selon l'une des revendications 1 à 5 ou 8, monté sur la première base de boîtier (50) et sur l'autre base de boîtier (52).

10. Le module solaire selon la revendication 9, **caractérisé en ce que** le sous-boîtier de la boîte de jonction (1) est disposé et fixé sur la première base du boîtier (50) et l'autre sous-boîtier de la boîte de jonction (2) est disposé et fixé sur l'autre base de boîtier (52) de telle manière qu'ils forment une boîte de jonction ou une autre boîte de jonction, chacune d'entre elles étant étanche de façon permanente et résistante aux intempéries.

11. Un procédé de production d'un module solaire, comportant des étapes suivantes
- fournir un produit semi-fini de module solaire selon l'une des revendications 6 à 8,
- disposer un produit semi-fini de boîte de jonction selon l'une quelconque des revendications 1 à 5 ou 8, de sorte que la première base de boîtier (50) du produit semi-fini de module solaire soit connectée au premier sous-boîtier de boîte de jonction (1) et que la ou les autres bases de boîtier (52) du produit semi-fini de module solaire soient connectées au ou des autres sous-boîtiers de boîte de jonction (2).
